# EUROPEAN PATENT APPLICATION

(11) **EP 4 752 456 A1**
(43) Date of publication of application: **03.06.2026**
(21) Application number: 24845609.7
(22) Date of filing: 23.07.2024
(51) Int. Cl.: F25B 1/00

(54) **HEAT MEDIUM REFORMING DEVICE, HEAT MEDIUM REFORMING METHOD, AND HEAT-MEDIUM-EMPLOYING EQUIPMENT**

(30) Priority: 25.07.2023 JP 2023120497
(71) Applicant: Power Support Co., Ltd., Tokyo 150-0013 (JP)
(72) Inventor: IGARASHI, Katsushi, Tokyo 150-0013 (JP)
(74) Representative: Maiwald GmbH
(86) International application number: PCT/JP2024/026266
(87) International publication number: WO 2025/023234

(57) **Abstract**

[Problem] Provided is a heat medium reforming device 2 improved to be suitable for use in a heat medium using device (air conditioner) 1.

[Solution] A generation unit 200 that generates, on the basis of a commercial power supply 6, an excitation signal that excites a heat medium, the excitation signal having a pulse width of 5 nsec to 100 nsec and a frequency of 5 kHz to 50 kHz, and a supply unit 120 that supplies the excitation signal generated by the generation unit 200 to the heat medium are included.

## Description

### BACKGROUND OF THE INVENTION

### 1. TECHNICAL FIELD

The present invention relates to a heat medium reforming device, a heat medium reforming method, and a heat medium using device, and particularly relates to a heat medium reforming device, a heat medium reforming method, and a heat medium using device that can be suitably used for heat medium using devices such as an air conditioner, a refrigerator/freezer, and a water heater.

### 2. DESCRIPTION OF THE RELATED ART

Recently, Russia's invasion of Ukraine and the like have led to a global energy crisis. Under this influence, a price of fuel has greatly increased, and an electricity rate has been raised also in Japan.

Non-Patent Literature 1 discloses a breakdown of power consumption estimated by the Agency for Natural Resources and Energy. According to Non-Patent Literature 1, for example,
- in the case of an office building, power consumption of air conditioning is about 48%,
- in the case of a wholesale/retail shop, power consumption of air conditioning is about 48%, and power consumption of refrigerating/cooling is about 9%,
- in the case of a food supermarket, power consumption of air conditioning is about 25%, and power consumption of refrigerating/cooling is about 35%,
- in the case of a medical institution, power consumption of air conditioning is about 38%,
- in the case of a hotel/inn, power consumption of air conditioning is about 26%, and
- in the case of a restaurant, power consumption of air conditioning is about 46%, and power consumption of a heating device and the like is about 22%.

Thus, it can be seen that most of the power consumption is caused by heat medium using devices.

Therefore, it can be said that implementing low power consumption of the heat medium using devices and saving power is very effective both from a viewpoint of each manufacturer and national economy and from a viewpoint of achieving an energy goal listed in Sustainable Development Goals (SDGs).

### CITATION LIST

### PATENT LITERATURE

Patent Literature 1: https://www.mhlw.go.jp/stf/houdou/2r9852000001o9by-att/2r9852000001oa3e.pdf

Meanwhile, although not disclosed at the time of filing of the present application, a patent specification of a granted patent application (Japanese Patent Application No. 2022-017482: Patent Literature 1) describes an invention of a lead sulfate coating removal device for removing a lead sulfate coating generated on an electrode of a lead-acid battery.

This lead sulfate coating removal device includes a generation unit that generates, on the basis of a signal extracted from the lead-acid battery, a removal signal of the lead sulfate coating having a peak value of 550 mA to 750 mA, a pulse width of 5 nsec to 100 nsec, and a frequency of 5 kHz to 50 kHz, and a supply unit that supplies the removal signal generated by the generation unit to the electrode of the lead-acid battery. This lead sulfate coating removal device has an excellent effect in that it can implement low power consumption of itself and does not damage the electrode of the lead-acid battery.

Although the lead sulfate coating removal device and the heat medium using device are different from each other in various points such as technical fields and applications, the present inventor has tried to attach the lead sulfate coating removal device disclosed in Patent Literature 1 to the heat medium using device with a slight improvement. As a result, surprisingly, the present inventor has found that it is possible to reduce an amount of power consumption of the heat medium using device.

Therefore, an object of the present invention is to provide a heat medium reforming device obtained by improving the lead sulfate coating removal device disclosed in Patent Literature 1 to be suitable for use in a heat medium using device.

### SUMMARY OF THE INVENTION

In order to achieve the above object, a heat medium reforming device of the present invention includes:
a generation unit that generates, on the basis of a commercial power supply, an excitation signal that excites a heat medium, the excitation signal having a pulse width of 5 nsec to 100 nsec and a frequency of 5 kHz to 50 kHz; and
a supply unit that supplies the excitation signal generated by the generation unit to the heat medium.

The generation unit may be implemented by an application specific digital integrated circuit.

Moreover, a conversion unit that is connected between the commercial power supply and the generation unit and converts an alternating current from the commercial power supply into a direct current may also be included. In this case, in Japan, the generation unit can generate the excitation signal on the basis of a voltage signal of 12 V to 24 V.

The excitation signal may have a peak value of 550 mA to 1000 mA.

Furthermore, a heat medium reforming method of the present invention includes:
generating, on the basis of a commercial power supply, an excitation signal that excites a heat medium, the excitation signal having a pulse width of 5 nsec to 100 nsec and a frequency of 5 kHz to 50 kHz; and
supplying the generated excitation signal to the heat medium.

Moreover, the heat medium reforming device described above is attached to a heat medium using device of the present invention.

### BRIEF DESCRIPTION OF THE DRAWINGS

FIG. 1 is an explanatory diagram illustrating a conceptual use example of a heat medium reforming device of an embodiment of the present invention;
FIG. 2 is a block diagram partially and functionally illustrating a circuit configuration of a generation unit in the heat medium reforming device illustrated in FIG. 1;
FIG. 3 is a diagram illustrating circuit topology of the generation unit illustrated in FIG. 2; and
FIG. 4 is a diagram illustrating a measurement result of a current value of a heat medium using device before and after attachment of the heat medium reforming device illustrated in FIG. 1.

### REFERENCE SIGNS LIST

| | |
|---|---|
| 1 | Heat medium using device |

| | |
|---|---|
| 2 | Heat medium reforming device |
| 3 | Indoor unit |
| 4 | Outdoor unit |
| 5 | Refrigerant pipe |
| 6 | Commercial power supply |
| 11 | Reference power supply circuit |
| 12 | Constant current circuit |
| 13A | Control circuit |
| 13B | Inter-terminal switch circuit |
| 14 | Oscillation circuit |
| 15 | First frequency dividing circuit |
| 16 | Second frequency dividing circuit |
| 17 | Level shift circuit |
| 18A | Drive circuit |
| 18B | Pulse driver circuit |
| 19 | Drive switch circuit |
| 100 | Plug |
| 110 | AC-DC adapter |
| 120 | Signal line |
| 120A | Positive terminal |
| 120B | Negative terminal |
| 130 | Drive resistor |
| 140, 150 | Voltage dividing resistor |
| 160 | Power supply unit |
| 170 | Signal generation unit |
| 180 | Switching circuit |
| 190 | Pulse driver circuit |
| 200 | Generation unit |

### DETAILED DESCRIPTION

Hereinafter, a heat medium reforming device, a heat medium reforming method, and a heat medium using device of an embodiment of the present invention will be described with reference to the drawings.

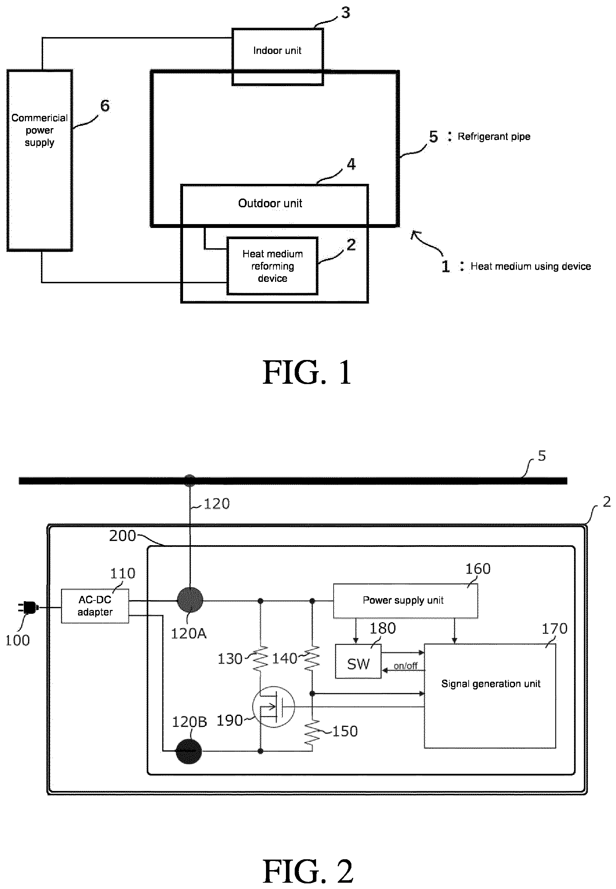

FIG. 1 is a conceptual explanatory diagram of an air conditioner that is a heat medium using device 1 of the embodiment of the present invention. The heat medium using device 1 includes, for example, a characteristic heat medium reforming device 2 in addition to a known indoor unit 3, outdoor unit 4, and refrigerant pipe 5. Note that FIG. 1 also illustrates a commercial power supply 6 to which the heat medium reforming device 2, the indoor unit 3, and the outdoor unit 4 are connected.

As illustrated in FIG. 1, the indoor unit 3 and the outdoor unit 4 are connected by the refrigerant pipe 5. These do not need to be prepared, and it is sufficient that the heat medium reforming device 2 is attached to those already installed in a building. As a matter of course, for example, an embodiment in which the heat medium using device 1 in a state where the heat medium reforming device 2 is attached to the refrigerant pipe 5 passing through the outdoor unit 4 is sold is not excluded from the present invention.

The indoor unit 3 includes a heat exchanger (not illustrated) that exchanges energy of heat transferred by a refrigerant. As is known, the heat exchanger is connected to the refrigerant pipe 5 in the indoor unit 3.

The outdoor unit 4 includes a compressor that compresses the refrigerant, a heat exchanger that exchanges energy of heat transferred by the refrigerant, and a decompressor that decompresses the refrigerant, all of which are not illustrated. As is known, the compressor, the heat exchanger, and the decompressor are all connected to the refrigerant pipe 5 in the outdoor unit 4. A positional relationship of these is in the order of the compressor, the heat exchanger, and the decompressor from upstream to downstream of the refrigerant during cooling.

The refrigerant pipe 5 often includes copper or aluminum, but is not limited thereto. The refrigerant pipe 5 is configured to circulate the refrigerant. Currently, the mainstream of the refrigerant is a refrigerant containing alternatives to chlorofluorocarbons such as hydrochlorofluorocarbon (HCFC), hydrofluorocarbon (HFC), and perfluorocarbon (PFC) as a main component and containing a small amount of lubricant. As a matter of course, a type of the refrigerant pipe 5 is not limited thereto.

In the refrigerant, it is considered that molecules of the alternatives to chlorofluorocarbons are clustered as the heat medium using device 1 is used. When the molecules of the alternatives to chlorofluorocarbons are clustered, a surface area of the molecules of the alternatives to chlorofluorocarbons is reduced, which causes a decrease in refrigerant function, that is, a decrease in heat exchange efficiency.

In conclusion, the heat medium using device 1 of the present embodiment is attached with the heat medium reforming device 2, and the heat medium reforming device 2 supplies an excitation signal to the refrigerant to reform the refrigerant. This improves or prevents the decrease in heat exchange efficiency. Note that the reform referred to herein also includes subdividing the molecules of the alternatives to chlorofluorocarbons when they are clustered.

The heat medium reforming device 2 is attached to the refrigerant pipe 5 in the outdoor unit 4, for example. As an example, but not limited thereto, the heat medium reforming device 2 can be attached between the heat exchanger and the decompressor in the refrigerant pipe 5. Furthermore, the heat medium reforming device 2 can also be attached to the refrigerant pipe 5 in the indoor unit 3, for example. As an example, but not limited thereto, the heat medium reforming device 2 can be attached between the heat exchanger in the indoor unit 3 and the decompressor in the outdoor unit 4.

The heat medium reforming device 2 and the refrigerant pipe 5 can be attached at a ratio of 1 : N to N : 1. That is, one or a plurality of the heat medium reforming devices 2 can be attached to one or a plurality of the refrigerant pipes 5. The number thereof to be attached may be determined by a peak value of an excitation signal to be described later generated by the heat medium reforming device 2 and a capacity of the refrigerant passing through the refrigerant pipe 5.

For example, in a case where there are two heat medium using devices 1 each having a small refrigerant capacity, one heat medium reforming device 2 can be attached to a refrigerant pipe 5 of one heat medium using device 1, and the refrigerant pipe 5 and a refrigerant pipe 5 of the other heat medium using device 1 can be attached in such a manner that the refrigerant pipes 5 are simply connected by a connecting wire such as a copper wire.

On the other hand, for example, in a case where there is one heat medium using device 1 having a large refrigerant capacity, a plurality of heat medium reforming devices 2 can be attached to a refrigerant pipe 5 of the heat medium using device 1. However, in this case, since attachment work generally increases, it is also considered that it is better to set the peak value of an excitation signal generated in the heat medium reforming device 2 to be high.

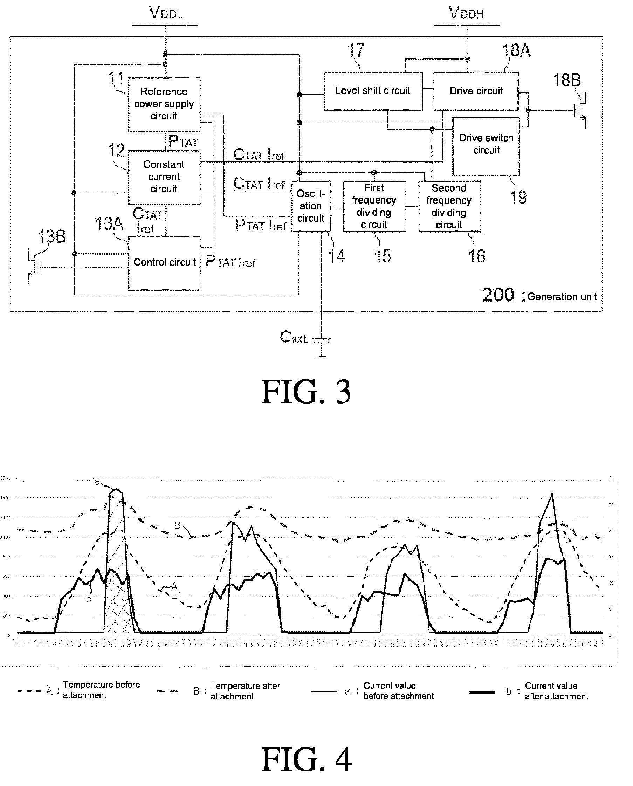

As will be described later in detail with reference to FIGS. 2 and 3, the heat medium reforming device 2 schematically includes a generation unit that generates an excitation signal that excites a refrigerant, and a supply unit that supplies the excitation signal generated by the generation unit to the refrigerant via the refrigerant pipe 5.

FIG. 2 is a block diagram partially and functionally illustrating a circuit configuration of the heat medium reforming device 2 illustrated in FIG. 1. FIG. 2 also illustrates the refrigerant pipe 5 illustrated in FIG. 1. The heat medium reforming device 2 is roughly divided into a power supply plug 100, an AC-DC adapter 110, and a generation unit 200 described below.

The power supply plug 100 connects a main body of the heat medium reforming device 2 to the commercial power supply 6. Since different outlet standards and plug standards are adopted depending on countries and regions, a type of the power supply plug 100 may be appropriately selected according to these standards.

The AC-DC adapter 110 converts an alternate-current (AC) voltage into a direct-current (DC) voltage in a case where the commercial power supply 6 is an AC power supply as in Japan. A value of the DC voltage after the conversion may be set to, for example, 12 V to 24 V. Note that, in a case where the commercial power supply 6 is a DC power supply, it is not needed to mount the AC-DC adapter 110. However, instead, it may be needed to mount a DC-DC adapter.

The generation unit 200 includes a signal line 120, a positive terminal 120A and a negative terminal 120B, a drive resistor 130, voltage dividing resistors 140 and 150, a power supply unit 160, a signal generation unit 170, a switching circuit (SW) 180, and a pulse driver circuit 190, which will be described below.

Some of active elements or passive elements of the generation unit 200 can be implemented by an application specific digital integrated circuit (application specific integrated circuit, hereinafter, referred to as "ASIC"). This will be described with reference to FIG. 3.

The positive terminal 120A is a terminal located downstream of the AC-DC adapter 110 and upstream of the drive resistor 130, the voltage dividing resistor 140, and the power supply unit 160 connected in parallel with each other.

As will be described later, the signal line 120 that transmits an excitation signal to the refrigerant pipe 5 is connected to the positive terminal 120A. However, since the excitation signal is an alternating current, the signal line 120 may be connected to the negative terminal 120B instead of the positive terminal 120A.

A part of a current passing through the positive terminal 120A flows through the drive resistor 130 toward the pulse driver circuit 190 located downstream of the drive resistor 130. Furthermore, another part of the current flows through the voltage dividing resistor 140 toward the voltage dividing resistor 150 and the signal generation unit 170. The rest of the current flows toward the power supply unit 160.

The power supply unit 160 includes, for example, a preceding-stage power supply circuit having a relatively high pressure and a subsequent-stage power supply circuit having a relatively low pressure, which are connected in series. Therefore, an output voltage V_{H} having a relatively high pressure of the preceding-stage power supply circuit is indirectly applied to the signal generation unit 170 via the switching circuit 180, and an output voltage V_{L} having a relatively low pressure of the subsequent-stage power supply circuit is directly applied to the signal generation unit 170. As a matter of course, physically, a voltage of one power supply circuit may be divided to obtain the output voltage V_{H} and the output voltage V_{L}.

The drive resistor 130 defines a current value flowing through the pulse driver circuit 190. A resistance value of the drive resistor 130 may be determined according to resistance values of the voltage dividing resistors 140 and 150, an input resistance value of the power supply unit 160, and the like. Note that, in a case where these are set as conditions to be described later, the resistance value of the drive resistor 130 may be set to about 10 Ω to 30 Ω (for example, about 15 Ω).

The voltage dividing resistors 140 and 150 define a value of a current flowing toward the signal generation unit 170. Each resistance value of the voltage dividing resistors 140 and 150 may be determined according to a resistance value of the drive resistor 130, an input resistance value of the power supply unit 160, and the like, but the resistance value of the voltage dividing resistor 140 can be set to about 0 Ω to 20 kΩ (for example, about 0 Ω), and the resistance value of the voltage dividing resistor 150 can be set to about 100 Ω to 300 kΩ (about 200 kΩ).

The switching circuit 180 is implemented by a transistor such as a field effect transistor (FET) in this example, and executes a switching operation according to an on/off signal to be described later output from the signal generation unit 170. When the switching circuit 180 is in an on state, the output voltage V_{H} of the preceding-stage power supply circuit of the power supply unit 160 is applied to the signal generation unit 170, and when the switching circuit 180 is in an off state, the application of the output voltage V_{H} to the signal generation unit 170 is stopped.

The signal generation unit 170 generates the above-described on/off signal to be supplied to the switching circuit 180 on the basis of the output voltages V_{H} and V_{L}. This on/off signal is supplied to the switching circuit 180. Furthermore, the signal generation unit 170 includes a constant current source output circuit, an oscillator, and a frequency dividing circuit, and generates a control signal for generating an excitation signal on the basis of the output voltages V_{H} and V_{L}. This control signal has a sawtooth waveform and becomes a gate current output to a gate of the pulse driver circuit 190.

Here, the signal generation unit 170 operates an excitation signal that finally excites the refrigerant passing through the refrigerant pipe 5 under the following conditions, for example, so as to be a pulse signal having a sawtooth waveform and having a peak value (a value of a peak of an output current of the heat medium reforming device 2) of 550 mA to 1000 mA, a pulse width of 5 nsec to 100 nsec, and a frequency of 5 kHz to 50 kHz, for example.

That is, the output voltage V_{H} of the preceding-stage power supply circuit of the power supply unit 160 is set to about 9.0 V to 11.0 V (for example, 10.0 V), the output voltage V_{L} of the subsequent-stage power supply circuit is set to about 5.0 V to 6.0 V (for example, 5.5 V), an oscillation frequency of the oscillator of the signal generation unit 170 is set to about 1.0 MHz to about 5.0 MHz (for example, about 2.5 MHz), and the frequency dividing circuit is configured by, for example, a divide-by-2 circuit and a synchronous divide-by-62 circuit.

As a result, a frequency can be set to about 0.6 MHz to about 2.5 MHz (for example, about 1.25 MHz) by the former, and a frequency can be set to about 9.67 kHz to about 40.32 kHz (for example, about 20.16 kHz) by the latter, and a pulse signal having a pulse width of about 5 nsec to about 100 nsec depending on the frequency after frequency division can be generated.

Then, when the pulse signal is supplied to the constant current source output circuit configured by a p-channel metal-oxide semiconductor (PMOS) transistor and a switch configured by an n-channel metal-oxide semiconductor (NMOS) to which the output voltages V_{H} and V_{L} are supplied, a control signal having a sawtooth waveform and having a peak value of about 550 mA to about 1000 mA, a pulse width of about 5 nsec to about 100 nsec, and a frequency of about 5 kHz to about 50 kHz can be generated.

The pulse driver circuit 190 generates an excitation signal according to a control signal output from the signal generation unit 170. The pulse driver circuit 190 can be implemented by, for example, a transistor such as an FET. In the case of this configuration, theoretically, the excitation signal has the same pulse width and the same frequency as those of the control signal.

The signal line 120 connects the positive terminal 120A and the refrigerant pipe 5. The signal line 120 supplies an excitation signal generated by the pulse driver circuit 190 to the refrigerant pipe 5. The signal line 120 can include, for example, a core wire and a sheath covering the core wire.

As a manner of connection between the positive terminal 120A and the refrigerant pipe 5, it is considered that, after one end of the core wire is connected to the positive terminal 120A, (1) the other end of the core wire is brought into contact with the refrigerant pipe 5 on condition that the refrigerant pipe 5 is not grounded, (2) the sheath is caused to extend along the refrigerant pipe 5, (3) the sheath is wound around the refrigerant pipe 5, and the like. Note that, in the above cases (2) and (3), the core wire is not brought into direct contact with the refrigerant pipe 5.

In the case (1) above, both an AC component and a DC component of the excitation signal are supplied to the refrigerant pipe 5 and the refrigerant passing through the refrigerant pipe 5. In the case (2) above, only the AC component of the excitation signal is supplied to the refrigerant pipe 5 and the refrigerant passing through the refrigerant pipe 5 by AC coupling. In the case (3) above, only the AC component of the excitation signal is supplied to the refrigerant pipe 5 and the refrigerant passing through the refrigerant pipe 5 by AC coupling.

As described above, since the refrigerant pipe 5 usually includes, for example, copper, in the case (1) above, a current flows when the excitation signal is supplied through the core wire of the signal line 120.

Furthermore, in the cases (2) and (3) above, even when the excitation signal is supplied through the sheath of the signal line 120, an electric field is applied to the refrigerant pipe 5, so that a current flows by AC coupling although the current is weak. In addition, it is considered that the refrigerant may be excited by AC coupling and a current may flow directly.

Meanwhile, in the refrigerant, it is considered that the molecules of the alternatives to chlorofluorocarbons are clustered as the heat medium using device 1 is used. In that case, the surface area of the molecules of the alternatives to chlorofluorocarbons is reduced, and the refrigerant function, that is, the heat exchange efficiency is reduced due to this.

In conclusion, the heat medium using device 1 of the present embodiment is attached with the heat medium reforming device 2, and supplies an excitation signal to the refrigerant to reform the refrigerant. It is assumed that the reform referred to herein also includes subdividing the molecules of the alternatives to chlorofluorocarbons when they are clustered.

Since the refrigerant is considered to be ionized, when a current flows through the refrigerant pipe 5, the refrigerant is to be affected by an electrochemical action. In addition, when the refrigerant is excited or a current flows through the refrigerant, a mechanical action that a cluster moves is to be exerted.

Regardless of whether it is right or wrong, as will be described later, it is an undeniable fact that a drive current of the compressor of the outdoor unit 4 actually decreases and a power saving effect of the heat medium using device 1 is confirmed by attaching the heat medium reforming device 2, and the fact is a basis supporting that the refrigerant has been reformed.

Note that it is also confirmed that, in a case where the excitation signal is a signal having a peak value of 550 mA to 1000 mA, a pulse width of 5 nsec to 100 nsec, and a frequency of 5 kHz to 50 kHz, one heat medium reforming device 2 can be suitably used for one or a plurality of heat medium using devices 1 in which a total capacity of the refrigerant is 20 L to 100 L (about 40 L in a case where the values exemplified in parentheses in the description using FIG. 2 are adopted).

FIG. 3 is a diagram illustrating circuit topology of the generation unit 200 in the heat medium reforming device 2 illustrated in FIG. 2. The generation unit 200 can be implemented by the ASIC as described above. In that case, the generation unit 200 includes a reference power supply circuit 11, a constant current circuit 12, a control circuit 13A, an inter-terminal switch circuit 13B, an oscillation circuit 14, a first frequency dividing circuit 15, a second frequency dividing circuit 16, a level shift circuit 17, a drive circuit 18A, a pulse driver circuit 18B, and a drive switch circuit 19, which will be described below.

Here, relationships between the portions illustrated in FIG. 2 and the portions illustrated in FIG. 3 do not indicate all corresponding portions in the respective drawings, and the portions do not necessarily correspond one by one, and thus, the relationships are organized conceptually and are roughly as follows.

That is,
- although not directly illustrated in FIG. 3, the power supply unit 160 illustrated in FIG. 2 corresponds to a portion generating a high power supply voltage V_{DDH} (corresponding to the "output voltage V_{H}" described with reference to FIG. 2) and a low power supply voltage V_{DDL} (corresponding to the "output voltage V_{L}" described with reference to FIG. 2),
- the drive resistor 130 illustrated in FIG. 2 corresponds to a portion (not illustrated) connected to the drive circuit 18A illustrated in FIG. 3,
- the voltage dividing resistors 140 and 150 illustrated in FIG. 2 correspond to the drive circuit 18A illustrated in FIG. 3,
- the switching circuit 180 illustrated in FIG. 2 corresponds to the drive switch circuit 19 illustrated in FIG. 3,
- the signal generation unit 170 illustrated in FIG. 2 corresponds to the reference power supply circuit 11, the constant current circuit 12, the control circuit 13A, the inter-terminal switch circuit 13B, the oscillation circuit 14, the first frequency dividing circuit 15, and the second frequency dividing circuit 16 illustrated in FIG. 3, and
- the pulse driver circuit 190 illustrated in FIG. 2 corresponds to the pulse driver circuit 18B illustrated in FIG. 3.

The reference power supply circuit 11 can be configured by a so-called bandgap reference (BGR) circuit, is supplied with the low power supply voltage V_{DDL}, generates a proportional to absolute temperature (P_{TAT}) signal serving as a reference signal (reference current), and outputs the P_{TAT} signal to the constant current circuit 12, the control circuit 13A, and the oscillation circuit 14 (note that what is used as the reference signal is denoted by "I_{ref}" in FIG. 3, and the same applies hereinafter).

The constant current circuit 12 is supplied with the low power supply voltage V_{DDL}, receives an input of the P_{TAT} signal output from the reference power supply circuit 11, generates a complementary to absolute temperature (C_{TAT}) signal on the basis of the P_{TAT} signal, and outputs the C_{TAT} signal to the control circuit 13A, the oscillation circuit 14, and the drive circuit 18A.

The control circuit 13A is supplied with the low power supply voltage V_{DDL}, receives inputs of the P_{TAT} signal output from the reference power supply circuit 11 and the C_{TAT} signal output from the constant current circuit 12, generates a merged signal of the P_{TAT} signal and the C_{TAT} signal, and controls on/off switching of an output of the merged signal.

Specifically, a threshold S_{L} and a threshold S_{H} to be compared with the low power supply voltage V_{DDL} are set in the control circuit 13A, and control is performed such that the merged signal is output to the inter-terminal switch circuit 13B when the threshold S_{L} ≤ the low power supply voltage V_{DDL} ≤ the threshold S_{H} holds, and the merged signal is not output to the inter-terminal switch circuit 13B in other cases.

The inter-terminal switch circuit 13B can be configured by, for example, an NMOS transistor, and includes a gate that receives an input of the merged signal from the control circuit 13A, a source connected to the positive terminal 120A, and a drain connected to the negative terminal 120B via an element such as a resistor or a diode for voltage and current adjustment, and switches electrical connection between the positive terminal 120A and the negative terminal 120B according to presence or absence of an output of the merged signal.

The oscillation circuit 14 is supplied with the low power supply voltage V_{DDL}, receives inputs of the P_{TAT} signal output from the reference power supply circuit 11 and the C_{TAT} signal output from the constant current circuit 12, generates a pulse signal on the basis of these signals, and outputs the pulse signal to the first frequency dividing circuit 15. The oscillation circuit 14 generates a pulse signal having an oscillation frequency of, for example, 2.5 MHz.

The first frequency dividing circuit 15 is supplied with the low power supply voltage V_{DDL}, receives an input of the pulse signal having the oscillation frequency of, for example, 2.5 MHz output from the oscillation circuit 14, divides the oscillation frequency of the pulse signal into 1/2, that is, 1.25 MHz, for example, and outputs the pulse signal to the second frequency dividing circuit 16.

The second frequency dividing circuit 16 is a synchronous frequency dividing circuit that receives an input of the pulse signal having the oscillation frequency of, for example, 1.25 MHz output from the first frequency dividing circuit 15, divides the oscillation frequency of the pulse signal into, for example, 1/62, that is, 20.16 kHz, and outputs the pulse signal to the level shift circuit 17 and the drive switch circuit 19.

Note that frequency division conditions of the first frequency dividing circuit 15 and the second frequency dividing circuit 16 may be such that a pulse width of the pulse signal output from the second frequency dividing circuit 16 is 800 nsec in this example. Therefore, it should be noted that the frequency division conditions are not limited to "1/2" frequency division or "1/62" frequency division, and the number of frequency dividing circuits is also not limited to "2"

The level shift circuit 17 is supplied with the low power supply voltage V_{DDL} and the high power supply voltage V_{DDH}, receives an input of the pulse signal having the pulse width of, for example, 800 nsec output from the second frequency dividing circuit 16, shifts levels of the low power supply voltage V_{DDL} and the high power supply voltage V_{DDH} on the basis of the pulse signal, and outputs a voltage signal after the level shift to the drive circuit 18A.

The drive circuit 18A can be configured by, for example, a PMOS transistor, is supplied with the high power supply voltage V_{DDH}, receives inputs of the voltage signal output from the level shift circuit 17, the C_{TAT} signal output from the constant current circuit 12, and a switch signal output from the drive switch circuit 19, generates a drive signal on the basis of the voltage signal and the C_{TAT} signal, and outputs the drive signal to the pulse driver circuit 18B according to the switch signal.

The drive switch circuit 19 can be configured by, for example, an NMOS transistor, is supplied with the low power supply voltage V_{DDL}, and includes a gate that receives an input of the pulse signal having the pulse width of, for example, 800 nsec output from the second frequency dividing circuit 16, a source that outputs the switch signal described above to the drive circuit 18A on the basis of the pulse signal, and a drain.

The pulse driver circuit 18B can be configured by, for example, an NMOS transistor, and includes a gate that receives an input of the drive signal output from the drive circuit 18A, a drain connected to an input terminal 100 via the drive resistor 130, and a source connected to an output terminal 120B.

FIG. 4 is a diagram illustrating measurement of an effect before and after attachment of the heat medium reforming device 2 illustrated in FIG. 1. A right vertical axis in FIG. 4 indicates temperature [°C] announced by the Japan Meteorological Agency at the time of measurement in the vicinity of a place where the effect is measured (0°C to 30°C, scale in increments of 5°C), a left vertical axis in FIG. 4 indicates a total drive current value [A/h] per unit time of the compressor provided in the outdoor unit 4 (0 A to 1600 A, scale in increments of 200 A), and a horizontal axis in FIG. 4 indicates a measurement time (0 : 00 to 23 : 00, scale in increments of 1 hour).

Note that, in the graph illustrated in FIG. 4, in order not to include a measurement value in an idling state of the heat medium using device 1 or an unusual measurement value which can be evaluated as a measurement error, about 5% included in ±2 standard deviations is excluded from an average value.

Measurement conditions are as follows.
(1) The same heat medium using device 1 to be measured was used before and after attachment of the heat medium reforming device 2. The heat medium using devices 1 to be measured are "RXYP140B", "RXYP560F", and "RZRP112BC" manufactured by DAIKIN INDUSTRIES, LTD., which are installed on the first floor of an office of a certain company in Nagai City, Yamagata Prefecture. The outdoor units 4 thereof were also installed on the first floor. Each of the heat medium using devices 1 to be measured has a use period of about 12 years, and no repair or part replacement was performed in the middle.
(2) The attached heat medium reforming device 2 adopted the values exemplified in parentheses in the description made with reference to FIG. 2 for specifications of the respective elements. That is, taking the drive resistor 130 as an example, the value of about 15 Ω was adopted. The heat medium reforming device 2 is attached to the refrigerant pipe 5 in the outdoor unit 4 of "RXYP140B", and the refrigerant pipe 5 is connected to the refrigerant pipes 5 of "RXYP560F" and "RZRP112BC" by a connecting wire.
(3) A measurement period before attachment of the heat medium reforming device 2 was set to be from Tuesday, May 9, 2023 to Friday, May 12. Furthermore, a measurement period after attachment of the heat medium reforming device 2 was set to be from Tuesday, June 13, 2023 to Friday, June 16. The reasons why a one-month interval is provided between these measurement periods are that, in a case where it is assumed that clustering has occurred in the refrigerant, it is considered that about one month will be needed after the heat medium reforming device 2 is attached to subdivide the clustering (subsequent experiments have indicated that attachment for as long as two weeks results in sufficient reform), and both the measurement periods are arranged on Tuesday to Friday.
(4) A current measurement device was attached to a power supply line of the compressor provided in the outdoor unit 4, and a drive current value of the compressor was measured every two minutes by the current measurement device. Note that a total of current values of "00 minute" to "58 minutes" every hour is summarized in FIG. 4 as a total drive current value of the compressor per unit time.

Measurement results and consideration thereof are as follows.

First, refer to a thick broken line A and a thin broken line B in FIG. 4. The thick broken line A indicates temperature in the effect measurement period before attachment of the heat medium reforming device 2. The thin broken line B indicates temperature in the effect measurement period after attachment of the heat medium reforming device 2.

From the graph illustrated in FIG. 4, it can be seen that the temperature in the measurement period according to the thick broken line A is relatively low because it is in May, and the temperature in the measurement period according to the thin broken line B is relatively high because it is in June.

Next, refer to a thick solid line a and a thin solid line b in FIG. 4. The thick solid line a indicates a current value in the effect measurement period before attachment of the heat medium reforming device 2. The thin solid line b indicates a current value in the effect measurement period after attachment of the heat medium reforming device 2.

It can be seen that, since the temperature according to the thick broken line A is relatively low, a rise of the current value indicated by the thick solid line a arrives in a late time zone and a fall thereof arrives in an early time zone, and since the temperature according to the thin broken line B is relatively high, a rise of the current value indicated by the thin solid line b arrives in an early time zone and a fall thereof arrives in a late time zone.

It can be seen that the current value indicated by the thick solid line a has a relatively large peak in spite that it is the measurement value when the temperature according to the thick broken line A is relatively low, and the current value indicated by the thin solid line b has a relatively small peak in spite that it is the measurement value when the temperature according to the thin broken line B is relatively high.

It can be seen that a hatched area of "/" in FIG. 4 represents a current amount according to the thick solid line a at 14 : 00 to 19 : 00 on the first day of the measurement of the effect (Tuesday, May 9, 2023) "before" attachment of the heat medium reforming device 2, and this current amount is large in spite that it is the measurement value when the temperature according to the thick broken line A is relatively low, and a hatched area of "\" in FIG. 4 represents a current amount according to the thin solid line b at 14 : 00 to 19 : 00 on the first day of the measurement of the effect (Tuesday, June 13, 2023) "after" attachment of the heat medium reforming device 2, and this current amount is small in spite that it is the measurement value when the temperature according to the thin broken line B is relatively high.

Originally, when the peaks of the current values indicated by the thick solid line a and the thin solid line b and the current amounts according to the above areas are compared with each other, behavior as illustrated in FIG. 4 is not to be obtained from a high and low relationship of the temperatures. This consideration can also be derived in a case where effect measurement results of the second to fourth days of the measurement of the effect are used as references.

However, since the behavior is actually as illustrated in FIG. 4, it means that the refrigerant is reformed and the heat exchange efficiency is improved by attachment of the heat medium reforming device 2 to the heat medium using device 1. Additionally, it is reasonable to consider that the reform means that, when it is assumed that the refrigerant is clustered, the clustering is subdivided.

Note that, although not departing from the scope of imagination, when it is assumed that the heat medium reforming device 2 has been attached to the heat medium using device 1 one month before Tuesday, May 9, 2023 to sufficiently reform the refrigerant, a conversion value of the current according to the thick solid line a illustrated in FIG. 4 is predicted to be considerably lower than the current according to the thin solid line b on the basis of the fact that there is a difference in temperature between Tuesday, May 9, 2023 and Tuesday, June 13, 2023.

Although it is difficult to accurately predict the area of the "/" portion converted in that case, it is likely that the conversion area in that case may be about 1/3 of the actual area of the "/" portion directly represented in FIG. 4.

In that case, an electricity rate in Japan can be calculated by a calculation expression of [basic rate according to contract power] + [power rate based on an amount of power consumption] + [renewable energy power generation promotion assessment], and according to the heat medium reforming device 2 of the present embodiment, since the current amount as a premise for calculating the amount of power consumption can be greatly reduced, it can be easily imagined that the power saving effect is enormous.

Regardless of whether such imagination is right or wrong, the heat medium reforming device 2 of the present embodiment and the heat medium using device 1 including the same can reform the refrigerant flowing through the refrigerant pipe 5 as can be understood from the measurement of the effect illustrated in FIG. 4, so that the power saving effect of the heat medium using device 1 can be obtained.

## Claims

1. A heat medium reforming device comprising:
a generation unit that generates, on the basis of a commercial power supply, an excitation signal that excites a heat medium, the excitation signal having a pulse width of 5 nsec to 100 nsec and a frequency of 5 kHz to 50 kHz; and
a supply unit that supplies the excitation signal generated by the generation unit to the heat medium.

2. The heat medium reforming device according to claim 1, wherein the generation unit is implemented by an application specific digital integrated circuit.

3. The heat medium reforming device according to claim 1, further comprising a conversion unit that is connected between the commercial power supply and the generation unit and converts an alternating-current voltage of the commercial power supply into a direct-current voltage.

4. The heat medium reforming device according to claim 1, wherein the excitation signal has a peak value of 550 mA to 1000 mA.

5. A heat medium reforming method comprising:
generating, on the basis of a commercial power supply, an excitation signal that excites a heat medium, the excitation signal having a pulse width of 5 nsec to 100 nsec and a frequency of 5 kHz to 50 kHz; and
supplying the generated excitation signal to the heat medium.

6. A heat medium using device attached with the heat medium reforming device according to claim 1.
